# EUROPEAN PATENT SPECIFICATION

(11) **EP 3 757 883 B1**
(45) Date of publication and mention of the grant of the patent: **27.05.2026**
(21) Application number: 20182414.1
(22) Date of filing: 26.06.2020
(51) Int. Cl.: G06V 10/25, G06V 20/69

(54) **AUTOMATED AND ROBUST METHOD FOR RECORDING NM-RESOLUTION 3D IMAGE DATA FROM SERIAL ULTRA-SECTIONS OF LIFE-SCIENCES SAMPLES WITH ELECTRON MICROSCOPES**
AUTOMATISIERTES UND ROBUSTES VERFAHREN ZUR AUFZEICHNUNG VON 3D-BILDDATEN IN NM-AUFLÖSUNG AUS SERIELLEN ULTRA-ABSCHNITTEN VON PROBEN AUS BIOWISSENSCHAFTLICHEN PROBEN MIT ELEKTRONENMIKROSKOPEN
PROCÉDÉ AUTOMATISÉ ET ROBUSTE POUR ENREGISTRER DES DONNÉES D'IMAGE 3D À RÉSOLUTION NM À PARTIR D'ULTRA-SECTIONS EN SÉRIE D'ÉCHANTILLONS DE SCIENCES DE LA VIE AVEC DES MICROSCOPES ÉLECTRONIQUES

(30) Priority: 28.06.2019 US 201962868617 P
(43) Date of publication of application: 30.12.2020
(73) Proprietor: FEI Company, Hillsboro, OR 97124-5793 (US)
(72) Inventor: Phelippeau, Harold, 5602 BS Eindhoven (NL); Levien, Cody, 5602 BS Eindhoven (NL); Franke, Tilman, 5602 BS Eindhoven (NL)
(74) Representative: Robinson, Louise Frances

(56) References cited:
- EP-A1- 2 132 708
- EP-A2- 2 634 749
- WO-A1-2012/155267
- WO-A1-2016/090148
- US-A1- 2019 122 854

## Description

### CROSS REFERENCE TO RELATED APPLICATION

This application claims the benefit of U.S. Provisional Application No. 62/868,617, filed June 28, 2019.

### FIELD

The disclosure pertains to acquisition of precisely matched sub-areas of multiple sections using scanning electron microscopy.

### BACKGROUND

Ultrastructural information on tissue samples has become increasingly important for life science research. While scanning electron microscopes (SEMs) can produce high resolution images, tissue samples do not efficiently generate the secondary or backscattered electrons required for SEM analysis. Therefore, samples are stained with heavy metals (e.g., osmium, lead) and then embedded in resin bocks for trimming or sectioning. These resulting blocks are around 1mm³ in size. Image formation in SEMs is limited to the block surface as electrons do not efficiently penetrate deeper than about 30 nm into the block. To generate 3D image data, the blocks must be cut into serial sections or thin layers removed from the block surface during imaging. Approaches based on removal of layers such as Serial Block Face Imaging or FIB-SEM Dual Beam Imaging destroy the sample, and users must acquire extensive data during imaging as sections cannot be reimaged. With samples cut into sections used in so-called Array Tomography, each section can be re-imaged as needed and users need not be concerning with sample destruction. Commercially available ultra-microtomes can reproducibly cut 50 nm sections and 100-300 serial sections are then placed on a conductive support, usually a 10 cm wafer or a metal plate of area of up to 10²cm².

It is rarely necessary to obtain high resolution image data from an entire tissue block. It is also not feasible: a 1 mm³ block, recorded at a resolution of 10x10x50 nm pixel-resolution, corresponds to 3 petabytes of data and would take 105 days to record at a beam dwell time of 3 µs. Target volumes or interest typically correspond to the size of one or a few biological cells, i.e., 30³ µm³ to 100³ µm³. The main bottleneck in SEM imaging of serial sections is navigating to the same 30² µm² to 100² µm² area in each of hundreds of serial sections that are scattered over the surface of the sample support. While an SEM technician can navigate in this way, very long times from many hours to days can be required to identify the appropriate section locations and to align these portions of the sections. For these and other reasons, alternative approaches are needed.

The prior art consists of documents:
US 2019/122854 Al (ZOTTA MATTHEW DANIEL [US] ET AL) 25 April 2019
WO 2012/155267 Al (FIBICS INC [CA]; PHANEUF MICHAEL WILLIAM [CA] ET AL.) 22 November 2012, and
WO 2016/090148 Al (ISOPLEXIS CORP [US]) 9 June 2016.

### SUMMARY

Disclosed are methods and apparatus that permit imaging of selected portions of specimen sections with high precision, i.e., with minimal section-to-section variability of placement of the imaging area, according to the appended claims.

In some examples, the preview images are processed for registration based on at least one feature in one or more of the preview images. Alternatively, each preview image is processed for registration based on a search template selected from the set of preview images. In typical examples, a set of specimen images associated with the ROI is obtained, wherein the specimen images have resolutions that are higher than resolutions associated with the preview images. In some examples, each preview image is processed for registration based on a correlation with a search template image selected from the set of preview images. In a particular example, the set of preview images includes N preview images 0, ... , N, wherein N is an integer, and at least one preview image is processed for registration based on a search template image selected from the set of preview images. For example, an i^{th} preview image is registered by comparison with an (i-1)^{th} preview image, wherein i is an integer greater than one and less than N. In some embodiments, each of the preview images of the set of preview images is registered by aligning the preview images or storing image transformations associated with alignment. In further examples, the preview images are associated with a first resolution, and a set of ROI images having a second resolution is obtained based on the registered preview images, wherein the second resolution is higher than the first resolution.

In other alternatives, an image that includes image areas associated with a plurality of specimen sections is obtained, and processed to identify the image areas associated with the specimen sections. Section locations are established based on the identified image areas, wherein each of the preview images is associated with a respective specimen section. In a representative example, stage coordinates associated with alignment of the image areas associated with the specimen sections are obtained and stored. In typical examples, ROI images are obtained for each of the selected sections and a three dimensional reconstruction of at least a portion of the ROI is produced based on the alignment of the preview images or on higher resolution images that are aligned based on alignment of the preview images.

Systems comprise an imager situated to obtain an overview image of a substrate that includes a plurality of specimen sections. A first image processor is coupled to receive the overview image and locate image portions associated with the plurality of specimen sections. A charged particle beam (CPB) imaging system is configured to produce preview images associated with selected portions of each of the specimen sections. A second image processor is coupled to receive the preview images and determine alignment of the preview images. In some examples, the CPB imaging system is configured to produce ROI images associated with each of the specimen sections and align the ROI images based on the alignment of the preview images. In representative examples, the first image processor and the second image processor are the same image processor. In other examples, the overview image has a first resolution, the preview images have a second resolution that is higher than the first resolution, and the ROI images have a third resolution that is higher than the second resolution. According to some examples, the first image processor is coupled to locate image portions associated with the plurality of specimen sections based on correlation with a section template. In further examples, the second image processor is coupled to align the preview images based on correlation with one or more search template or based on feature identification. In some examples, the first image processor is coupled to determine substrate stage locations corresponding to alignment of the images of the specimen sections and the second image processor is coupled to determine substrate stage locations corresponding to alignment of the preview images.

Methods comprise, with a processor, identifying a plurality of specimen sections of a 3D sample specimen in an overview image of the plurality of sections of a 3D sample based on a section template, wherein the overview image is an optical image associated with a first image resolution. The images of the identified plurality of specimen sections are registered and a refinement region that includes a region of interest in at least a selected set of the images of the identified sections is selected. Preview images that include each of the refinement regions are obtained, the preview images being electron beam based images having a second image resolution that is higher than the first image resolution. The preview images are registered with respect to each other using feature identification, Electron beam based images associated with the ROI are obtained for each of the preview images, wherein the electron beam based images have a third image resolution that is higher than the second image resolution. The registered electron beam based images associated with the ROI for each of the registered preview images are stored.

These and other features of the disclosed technology are set forth below with reference to the accompanying drawings.

### BRIEF DESCRIPTION OF THE DRAWINGS

FIGS. 1A-1B illustrate representative methods of aligning and registering images from sectioned samples.
FIGS. 2A-2I illustrate images associated with alignment of section images.
FIG. 3 illustrates a representative imaging apparatus that produces registered images.
FIG. 4 illustrates a representative computing environment for control of image acquisition and processing.
FIG. 5 illustrates a method of aligning images.
FIGS 6A-6E illustrate a representative method of aligning section images.
FIG. 7 illustrates a representative method of obtaining a series of images for 3D tomography.
FIGS. 8A-8B illustrate section imaging with and without distortion.
FIG. 8C illustrate sections situated on a tape.
FIGS. 8D-8E illustrate section image artifacts associated with section images obtained with different section locations in an imaging field of view.
FIGS. 8F-8G illustrate reduction or elimination of section image artifacts associated with section image stitching by aligning sections in an imaging field of view.
FIGS. 9A-9D illustrate alignment of images in an image stack using preview images with a ribbon of specimen sections.

### DETAILED DESCRIPTION

### Definitions and Terminology

As used herein, "image" refers to a viewable image presented on a display or otherwise made available for viewing by a user as well as stored representations that are adapted to produce such viewable images. Examples of such representations include files in .jpg, .tiff, .bmp, and other formats and stored in a computer readable medium such as a hard disk drive, memory, or otherwise stored. Images can be stored as intensity or other values as functions of coordinates such as intensity I(x, y), wherein x, y are Cartesian coordinates. Other representations are possible such as three dimensional representations using Cartesian, polar, or other coordinates. For convenient description, methods are described as sequences of particular steps, but in some cases these steps can be performed in different orders, and one or more steps can be underway at the same time. In some cases, images or image portions are referred to as being aligned or in alignment. As used herein, these terms referred to images of specimen sections that are processed by rotations and/or translations so as to overlap to correspond to locations and orientations in a specimen prior to sectioning. Alternatively, these terms refer to images processed to identify rotations, translations, or other processing that permits producing images having the specimen locations and orientations prior to sectioning. For example, image coordinates can be updated so that all images are specified with a common coordinate system, or each image can be defined with respect to its own or other coordinate system, but with offsets and/or rotations available to superpose or otherwise align the images as needed. In either case, images can then be used to determine specimen structure through a stack of section images. Alignment can be used to determine stage coordinates in an optical or CPB microscope for acquisition of suitable images.

In some examples, correlation with one or more reference images or templates is used to determine image alignment. A fixed or variable reference or template can be used. Typically, precise alignment of layer images uses reference images that can vary from section image to section image in a stack. For example, an image processed for alignment with respect to a reference can be used as a reference for aligning a subsequent image. A reference image can be changed at least section image in the stack or every 2^{nd}, 3^{rd}, 4^{th}, 5^{th}, or other interval. Features can be tracked from layer to layer, or a correlation can be computed between layers, and a correlation maximum used to indicate alignment.

### Overview of Examples

Examples are described with processing sections of a specimen obtained using a microtome. Multiple sections are situated on a substrate and a first alignment procedure ("coarse alignment") is used to locate the sections with respect to each other based on comparison or correlation with a section template that typically is selected by a user from among section images contained in an overview image of the substrate. **In** a second alignment procedure ("fine alignment"), so-called preview images of some or all sections are obtained. An ROI template is selected from the selected sections, and a first preview image is aligned based on comparison or correlation with the ROI template. The ROI template is updated based on the aligned first preview image, and a second preview image is aligned based on comparison or correlation with the updated ROI template. This process is repeated for all preview images of interest. An ROI is then selected by a user, and the aligned high resolution images from some or all sections can be acquired. In the examples discussed below, overview images are optical images and subsequent images (preview images and high resolution images) are electron beam images. However, optical or charged-particle-beam images can be used for either such as those produced with electron microscopes, light microscopes, optical scanning microscopes, ion beam images, or others.

### Example 1. Tomographic Imaging from Specimen Sections

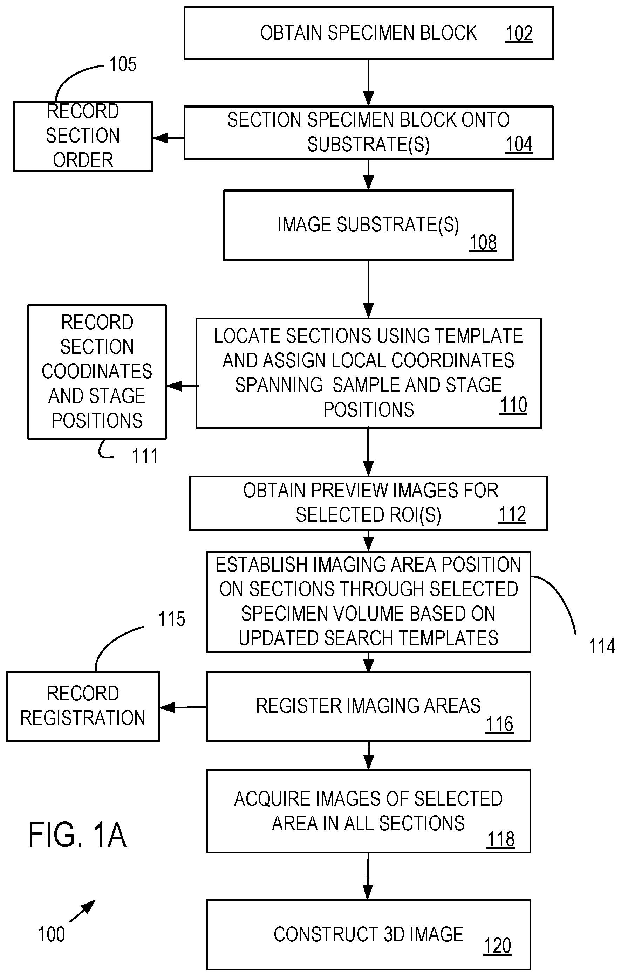

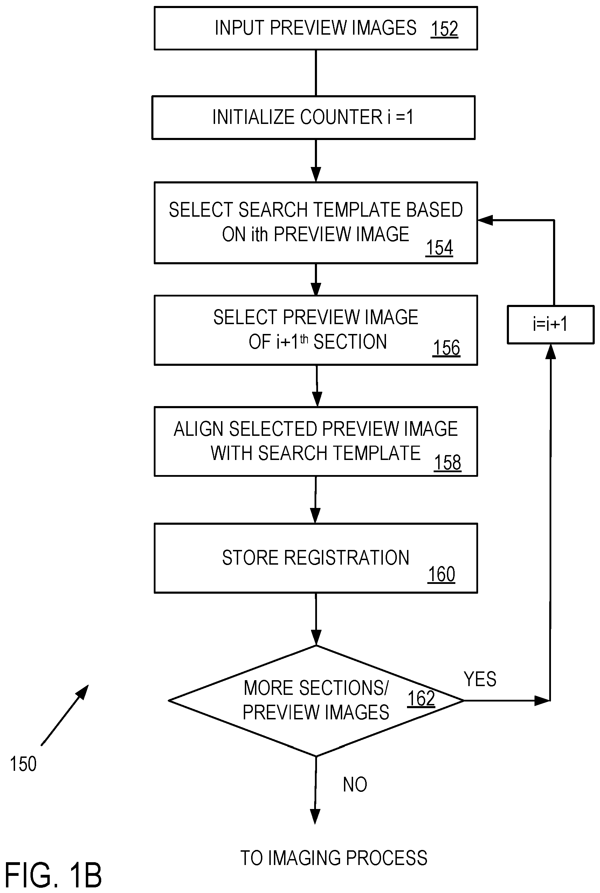

The disclosed methods and apparatus can be used in 3D and other imaging of specimens such as biological specimens. A representative method 100 is illustrated in FIG. 1. At 102, a specimen block or other 3D specimen is obtained. The specimen block is then sectioned at 104 with, for example, a high precision microtome, and the sections arranged on a substrate, typically in sequence as removed from the specimen block. Silicon wafers are convenient substrates. A set of one or more substrates retaining multiple specimen sections is referred to herein as an "array tomography sample" or simply "sample." The sections can be arranged arbitrarily with appropriate tracking of the sections to retain the section order if desired although sequential ordering is generally more convenient. For example, section ordering can be stored at 105. Sections obtained from a 1 mm³ specimen block generally do not fit on a single substrate and 10-100 wafers can be needed. In most examples, sections are arranged in rows that extend along parallel axes (such as from left to right) and each subsequent row begins at a location in a new row that is proximate a location of an initial section in a prior row. Alternatively, a new row can be initiated by placing a section proximate a last section of the previous row; returning to a leftmost location upon completion of a row. Although not discussed in detail, the specimen block and the sections can be stained or labelled for light microcopy or electron beam microscopy as needed. For example, fluorescent immuno-labels and heavy metals can be used for light microscopy and electron beam microscopy, respectively. In some cases, the sections are arranged on a tape which is then situated on a substrate. The substrate is coupled to a stage for positioning for optical and electron beam imaging and feature and image positions can be specified based on stage coordinates and rotations.

The sections as arranged on the substrate (i.e., the sample) are imaged with an optical imaging device such as a camera at 108 to obtain one or more overview image. For convenience, in the following, it is assumed that only a single substrate and a single overview image are needed. The overview image is processed at 110 to identify the sections and obtain associated locations, typically as xy-coordinates in a coordinate system having x- and y-axes in a plane of the substrate surface that retains the sections. Stage positions (and orientations) are assigned to each section and recorded at 111. The sections can be detected using a user-defined template and the overview image with, for example, optical image cross-correlation with the template. The template is typically selected from among the section images in the overview image, and is referred to herein as a "section template." Multiple portions of one or more overview images can be processed with cross-correlation in parallel so that sections can be identified and placed more rapidly. Image resolutions of about 2 µm/pixel are used so that images or portions thereof can be used in correlation operations - in high resolution images, differences between sequential images can be too large for successful cross-correlation. An image of a particular section can be identified for use as the section template for location of all sections.

With sections located and ordered, section preview images (typically using an electron beam) are obtained at 112. The preview images are associated with portions of the section that contain a region of interest (ROI). In some examples, the preview images are obtained based on user outlining provided on a section image, and a graphical user interface can be provided for such selection. Preview images typically cover an entire section and have sizes defined by the section template plus 1%, 5%, or 10%, but other sizes can be used. These preview images are generally obtained with resolutions superior to those used in section location (for example, resolutions of better than 1µm/pixel). The preview images can exhibit variable artefacts such as distortion within an image, variable magnification between images, and others. As a result, typically no stage position provides perfect or even satisfactory stack alignment of sections for ROIs at differing locations in the preview images. However, positions suitable for each ROI can be obtained using feature-based image alignment or correlation using a search template that can be updated during processing so that image portions in and proximate each ROI image portion can be aligned. The search template is generally selected as at least a portion of the first preview image. At 114, the preview images are aligned by tracking an image feature from one preview image to a next using the search template. In some examples, a feature used for tracking is updated after one or more preview images are aligned to accommodate variability in the specimen and the search template us updated after each preview image is processed. In some examples, a selected preview image is used as the search template for cross-correlation with one or more other preview images. During processing, the search template can be updated as needed. Each ROI typically requires an independent feature-based or other alignment due to image distortion and other image artefacts, but ROIs that are sufficiently close together may not. An acceptable degree of closeness can be a function of image artefact magnitude and proximity and it may be more convenient to align each ROI using dedicated feature based alignment for each. At 116, alignment and registration values for the preview images can be obtained and stored at 115, typically in a computer readable medium.

Once the image stacks are aligned, high resolution images (such as 2 nm/pixel) can be acquired at 118 and used in 3D reconstruction at 120. In some examples, preview image alignment can be repeated, typically by acquiring and processing additional preview images with a higher resolution than the initial preview images. If an additional ROI is to be investigated, processing returns to 112 and suitable preview images associated with the additional ROI are obtained and processed. In this example, sections have been previously located and the related method steps are unnecessary.

### Example 2. Preview Image Alignment

FIG. 1B illustrates a representative method 150 of image stack alignment using preview images or other image portions. For convenient explanation, FIG. 1B is discussed with reference to an image stack of sections 0, 1, 2, ..., *N*, wherein *N* is an integer, with section 0 being a top most section. At 152, a set of preview image is received, and at 154, a search template is selected, typically a preview image of the 0^{th} section (or other section). At 156 a preview image of an *i*^{th} layer is selected and compared and aligned with the search template at 158, typically using cross-correlation. At 160, registration coordinates are stored, generally as stage coordinates for subsequent alignment. At 162, it is determined if additional preview images are to be aligned, and if so, an updated search template is selected at 154. In some cases, the updated search template is the *i*^{th} image previously used as aligned, while in other examples, the initial reference image (the 0^{th} image) is used. In other examples, a different updated search template is selected after processing 2, 5, 10, 20, 50, or 100 images, or a most recently used preview image can be selected. Varying the updated search template through the section stack permits registration to be maintained even in the presence of image features that vary through the stack. In some cases, only an initially selected updated search template is adequate, and any of the preview images can be used. More typically, continuously updating the updated search template from section to section allows registration over hundreds of sections even with a biological structure that is progressively changing. With alignment complete, the ROI portions of the preview images can be used for obtaining final high resolution images and establishing a 3D image of a volume region of interest.

Stack alignment can proceed from within the stack and need not start with a top or bottom section. For example, a *k*^{*t*h} preview image can be selected as an updated search template, and (*k-1)*^{th} and *(k+1)*^{th} preview images can be aligned, and the search template refreshed as preferred. Preview images can be processed serially, or multiple preview images can be processed in parallel as preferred.

Sample portions of interest typically extend only through selected sections of the specimen block. In such cases, images associated with all sections and all areas of the sections are not required. A user can conveniently select any sections and areas of interest using a graphical user interface.

### Example 3. Representative Specimen Processing

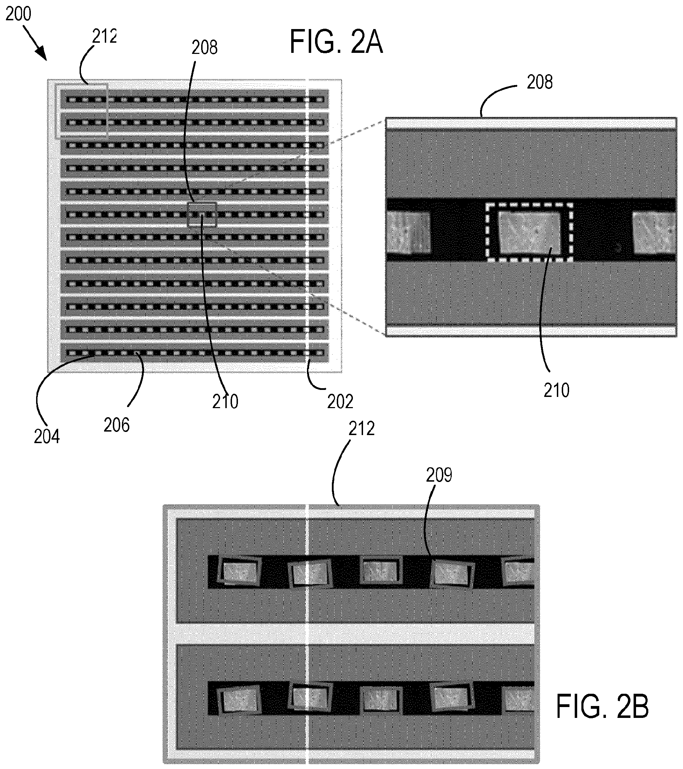

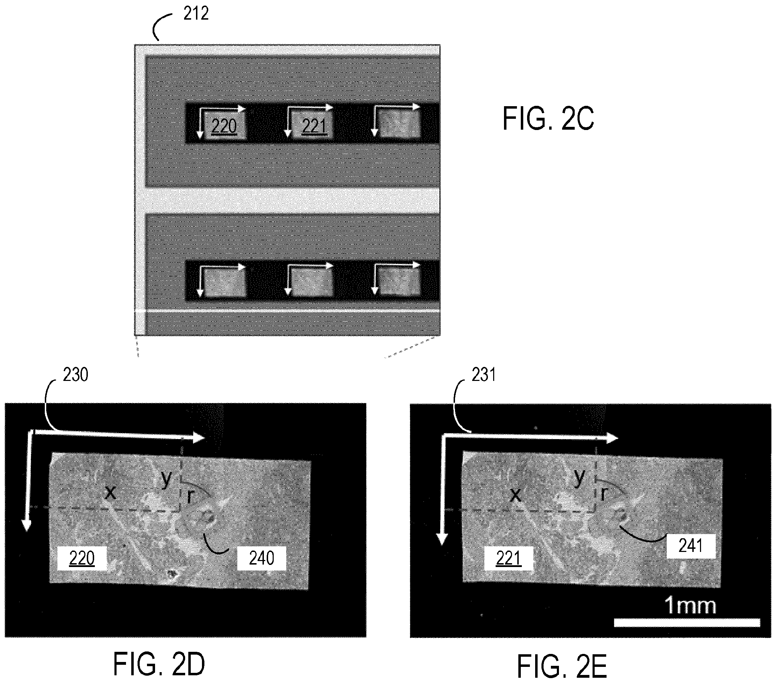

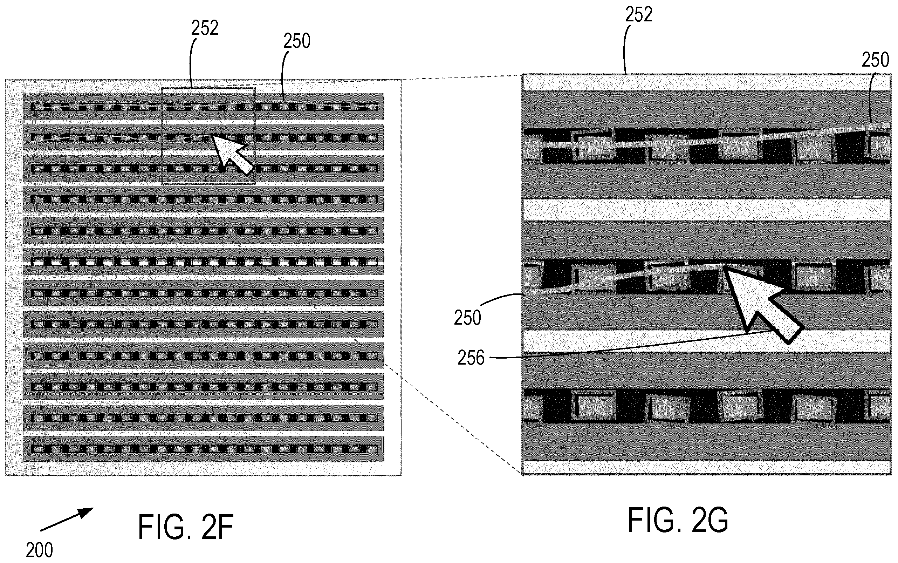

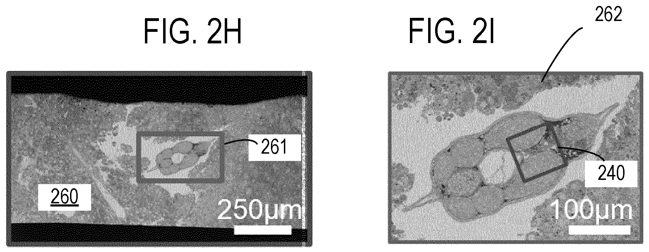

FIGS. 2A-2I illustrate specimen processing and ROI image alignment. FIG. 2A shows an image 200 of substrate 202 supporting a series of tape strips such as representative tape strip 204 which retain sample sections such as representative sample section 206. Twelve tape strips are shown, but more or fewer can be used and the sample sections can be situated directly on the substrate 202. Multiple such substrates can be needed to retain all sections of a specimen. The image 200 is an overview image and a particular image portion 208 of the overview image 200 is selected, containing an image 210 of a single section. The image portion 208 is selected for use as a section template in identifying and locating other sections, typically using correlation of the section template with the overview image 200; relative displacements associated with large values of a correlation coefficient are then identified and coordinates obtained so that section image locations are established.

FIG. 2B illustrates an image portion 212 that includes images of a plurality of sections which have been identified as indicated by frames such as frame 209 of which sections 220, 221 are shown further in FIG. 2C. Images of each of these sections is illustrated with associated coordinate axes of a two dimensional xy coordinate system. For example, as shown in FIGS. 2D-2E, sections 220, 221 are associated with respective coordinate axes 230, 231. In this example, section dimensions are about 1 mm by 0.5 mm, and locations of imaging regions 240, 241 with respect to the respective coordinate axes 230, 231 are shown, along with rotation angles *r*. Imaging regions are generally needed only in selected sections, and the sections can be conveniently selected with a trace 250 that extends through all sections of interest as shown in FIGS. 2F-2G. The selection of sections can be made in various ways, such drawing the trace 250 on a displayed image of the substrate and sections using a computer-based pointing device. A cursor 256 can be used in establishing the trace 250 and manipulated via computer-executable instructions for a mouse, trackpad, keyboard, or other device.

The selected sections are identified and have specified locations with respect to each other, but are generally not well aligned in a Region of Interest (ROI). Alignment and registration is limited by magnification errors, rotation errors, nonlinear distortion in tiled SEM overview images that have been acquired with large fields of view, mismatches at section borders, and the sections cannot be satisfactorily aligned and arranged in a stack. As shown in FIGS. 2H-2I, a portion 260 of the section 220 is selected and a preview image 262 of an area 261 is obtained. The preview image 262 and the area 261 are selected to include the ROI that contains specimen features of interest. The preview image 262 is typically a higher-resolution image than any previous images such as the overview image. Preview images that contain an ROI for other selected sections can obtained as well, and the preview images are then aligned using a correlation or other process as discussed above. In preview image based alignment, an initial or previously aligned preview image or portion thereof can be used as a search template, and the search template updated after processing each preview image. While preview images from each section can be aligned, typically only preview images indicated with the trace 250 are aligned, but in some examples, hundreds of such preview images are selected.

After preview image alignment, the preview images can be provided for use in producing a 3D image of the ROI. Alternatively, this alignment permits acquisition higher resolution images a substrate stage can be used to suitably position the sections. If desired, these additional images can be aligned as well. In any case, the resulting image stack permits 3D reconstruction with minimal operator intervention.

In some examples, a user specifies an area surrounding an ROI and both linear (e.g., xy coordinates) and rotation angles are adjusted to match with a search template. For examples, an ROI is selected from a first section as the search template, and a corresponding portion of a second section is aligned to match by applying appropriate translations and rotation. With the first and second section aligned, an image portion around the ROI in an image of the second section is selected for use in processing a third section. This process continues until all sections of interest have been processed. In some examples, the images are not adjusted but suitable xy offsets and rotation angles are stored for use in subsequent image processing. As discussed above, other areas of the sections will require different offsets and rotations and images can be acquired, processed, aligned, and stored for multiple areas.

### Example 4. Imaging System

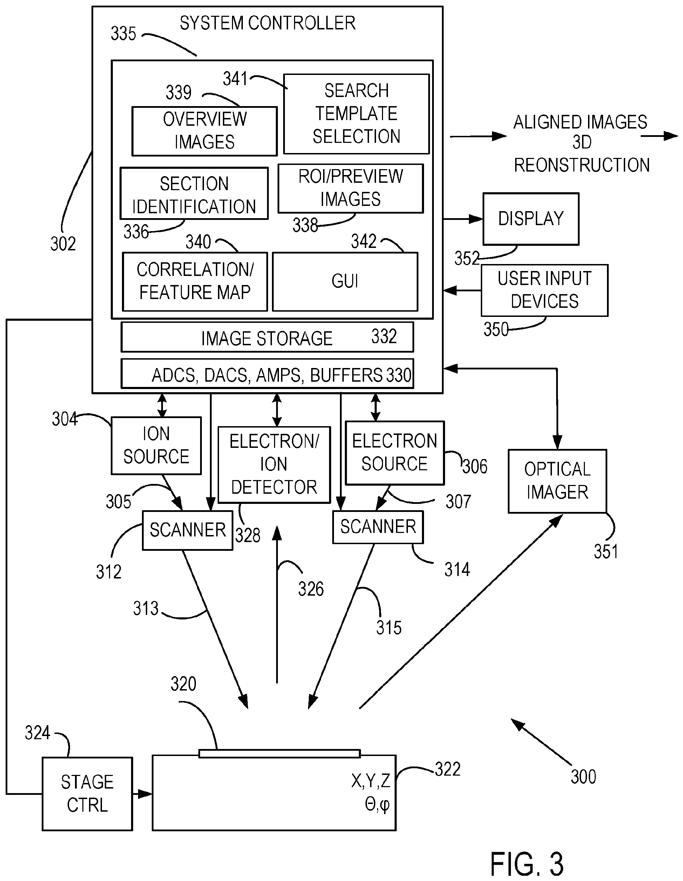

Referring to FIG. 3, an imaging system 300 includes a system controller 302 that is coupled to an ion beam source 304, an electron beam source 306 that produce an ion beam 305 and an electron beam 307, respectively. Respective scanners 312, 314 are situated to direct a scanned ion beam 313 and a scanned electron beam 315, respectively, with respect to a specimen 320. In some application, images are obtained based on the scanned electron beam 315, and the scanned ion beam 313 is used for specimen modification. However, images can be obtained with either one or both of the scanned ion beam 313 and the scanned electron beam 315. In some cases, an imaging system includes only one of an electron beam source and an ion beam source. For many biological specimens, only an electron beam is required.

The specimen 320 is secured to a stage 322 that is coupled to a stage controller 324 that is in turn coupled to the system controller 302. The stage 322 generally can provide one or more translations, rotations, or tilts as directed by the system controller 302. A beam 326 responsive to the scanned ion beam 313 or the scanned electron beam 315 is directed to an electron or ion detector 328 which is coupled to system electronics 330 which can include one or more analog-to-digital convertors (ADCs), digital to analog-convertors (DACs), amplifiers, and buffers for control of the detector 328 and processing (amplification, digitization, buffering) of signals associated with the detector 328. In other examples, a photon detector is used that produces an electrical signal that is further processed by the system electronics. In most practical examples, at least one ADC is used to produce a digitized detector signal that can be stored in one or more tangible computer readable media (shown as image storage 332) as an image. In other examples, image storage is remote via a communication connection such as a wired or wireless network connection. The beam 326 can be scattered portions of the scanned ion beam 313, the scanned electron beam 315, secondary electrons, ions, or neutral atoms. An optical imager 351 such as a camera is coupled to produce an image of the specimen 320 to, for example, produce a substrate image that shows multiple substrate sections. As noted above, such images can be processed to identify, locate, and align each of the sections for further (typically higher resolution) imaging using a charged particle beam (CPB).

The system controller 302 is coupled to a memory 335 that stores processor-executable instructions for image processing such as section identification 336, correlation and feature alignment 340, selection of ROIs and preview image areas 338, storage and acquisition of overview images 339, search template selection and updating 341, and to provide a GUI 342 for various functions, including selecting which sections are to be processed and define a visible trace showing sections of interest. Images (both CPB and optical can be stored in a memory portion 332. Stage coordinates (including rotations) can be stored in memory portion 332 as well. The system controller 302 establishes image acquisition parameters and is in communication with the stage controller 324. Specimen images (such as preview images, section images, substrate images, overview images) can be presented on a display 352, and system control and imaging parameters can be specified using internally stored values from the memory 335, or provided by a user with one or more user input devices 350.

It will be appreciated that the layout of FIG. 3 is for convenient illustration, and actual alignments of various beam sources, the optical camera 352, and the CPB detector(s) are not shown. While a dual beam (ion/electron) system is illustrated, one or both can be used, and in many practical examples such as electron microscopy, only an electron beam is used for imaging.

### Example 5. Representative Computing Environment

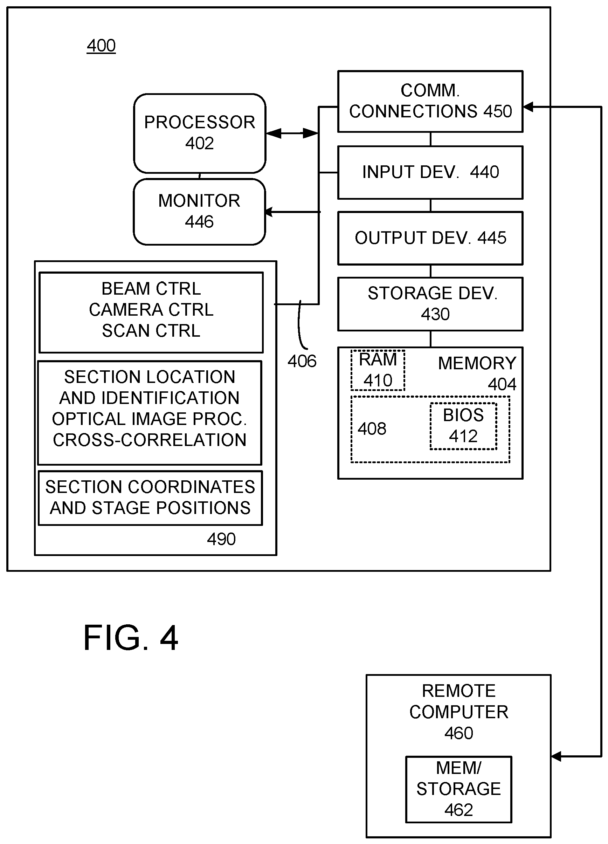

FIG. 4 and the following discussion are intended to provide a brief, general description of an exemplary computing environment in which the disclosed technology may be implemented. In particular, some or all portions of this computing environment can be used with the above methods and apparatus to, for example, control beam scanning and image processing to identify and align section images, preview images, and image storage. Although not required, the disclosed technology is described in the general context of computer executable instructions, such as program modules, being executed by a personal computer (PC). Generally, program modules include routines, programs, objects, components, data structures, etc., that perform particular tasks or implement particular abstract data types. Moreover, the disclosed technology may be implemented with other computer system configurations, including hand held devices, tablets, multiprocessor systems, microprocessor-based or programmable consumer electronics, network PCs, minicomputers, mainframe computers, and the like. The disclosed technology may also be practiced in distributed computing environments where tasks are performed by remote processing devices that are linked through a communications network. In a distributed computing environment, program modules may be located in both local and remote memory storage devices. In some cases, such processing is provided in an SEM. The disclosed systems can serve to control image acquisition and provide a user interface as well as serve as an image processor.

With reference to FIG. 4, an exemplary system for implementing the disclosed technology includes a general purpose computing device in the form of an exemplary conventional PC 400, including one or more processing units 402, a system memory 404, and a system bus 406 that couples various system components including the system memory 404 to the one or more processing units 402. The system bus 406 may be any of several types of bus structures including a memory bus or memory controller, a peripheral bus, and a local bus using any of a variety of bus architectures. The exemplary system memory 404 includes read only memory (ROM) 408 and random access memory (RAM) 410. A basic input/output system (BIOS) 412, containing the basic routines that help with the transfer of information between elements within the PC 400, is stored in ROM 408.

The exemplary PC 400 further includes one or more storage devices 430 such as a hard disk drive for reading from and writing to a hard disk, a magnetic disk drive for reading from or writing to a removable magnetic disk, and an optical disk drive for reading from or writing to a removable optical disk (such as a CD-ROM or other optical media). Such storage devices can be connected to the system bus 406 by a hard disk drive interface, a magnetic disk drive interface, and an optical drive interface, respectively. The drives and their associated computer readable media provide nonvolatile storage of computer-readable instructions, data structures, program modules, and other data for the PC 400. Other types of computer-readable media which can store data that is accessible by a PC, such as magnetic cassettes, flash memory cards, digital video disks, CDs, DVDs, RAMs, ROMs, and the like, may also be used in the exemplary operating environment.

A number of program modules may be stored in the storage devices 430 including an operating system, one or more application programs, other program modules, and program data. A user may enter commands and information into the PC 400 through one or more input devices 440 such as a keyboard and a pointing device such as a mouse. For example, the user may enter commands to initiate image acquisition or select whether, for example, optical flow or image differences are to be used to locate charging regions. Other input devices may include a digital camera, microphone, joystick, game pad, satellite dish, scanner, or the like. These and other input devices are often connected to the one or more processing units 402 through a serial port interface that is coupled to the system bus 406, but may be connected by other interfaces such as a parallel port, game port, universal serial bus (USB), or wired or wireless network connection. A monitor 446 or other type of display device is also connected to the system bus 406 via an interface, such as a video adapter, and can display, for example, one or more section images (i.e., images used in identifying and locating sections), preview images, ROI images or other raw or processed images such as images after alignment or with displayed values of translations and rotations needed for alignment, The monitor 446 can also be used to select sections for processing or particular image alignment and alignment procedures such as correlation, feature identification, and preview area selection or other image selection. Other peripheral output devices, such as speakers and printers (not shown), may be included.

The PC 400 may operate in a networked environment using logical connections to one or more remote computers, such as a remote computer 460. In some examples, one or more network or communication connections 450 are included. The remote computer 460 may be another PC, a server, a router, a network PC, or a peer device or other common network node, and typically includes many or all of the elements described above relative to the PC 400, although only a memory storage device 462 has been illustrated in FIG. 4. The personal computer 400 and/or the remote computer 460 can be connected to a logical a local area network (LAN) and a wide area network (WAN). Such networking environments are commonplace in offices, enterprise wide computer networks, intranets, and the Internet. In some examples, a stack of aligned image is transmitted to a remote system for 3D image reconstruction or other processing.

As shown in FIG. 4, a memory 490 (or portions of this or other memory) store processor executable instructions for image acquisition to establish dose, frame time, beam current, scan rate, and image processing. In addition, the memory490 includes processor executable instructions for setting cross-correlations, image alignment such as image rotation and translation, selection of reference images and ROIs, recording stage coordinates for alignment. In some examples, processor-executable instructions produce displayed images showing section identification, processing of preview images, and acquisition of additional images.

### Example 6. Representative Method of Section Image Alignment

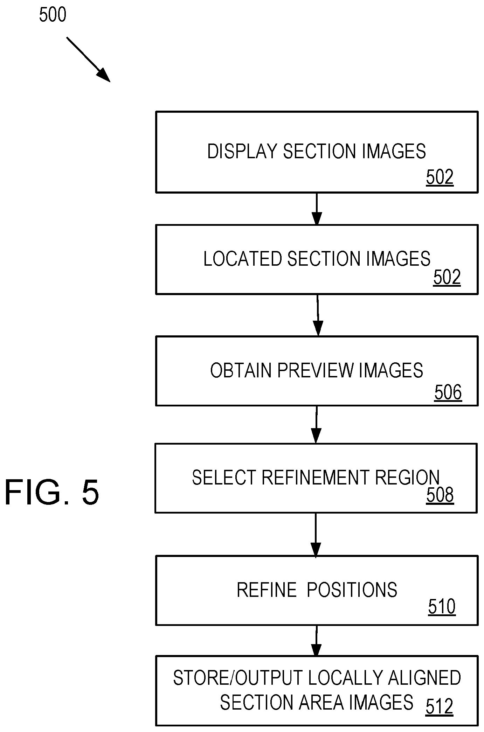

FIG. 5 illustrates a method 500 for producing a set of aligned images of selection portions of multiple specimen sections. At 502, substrate images (typically optical images) containing a plurality of section images are obtained and displayed, and at 502, located section images are obtained (typically, SEM images) and displayed. At 506, preview images are obtained and a refinement region is selected from one or more section images at 508. At 510, image positions are refined, and at 512, aligned images are stored or output. Alternatively, appropriate translations and rotations can be stored for each image, and unaligned images along with these translations and rotations can be output. In some cases, the method 500 proceeds with little user input beyond selection of an ROI.

### Example 7. Sample Preparation and Processing for Tomography

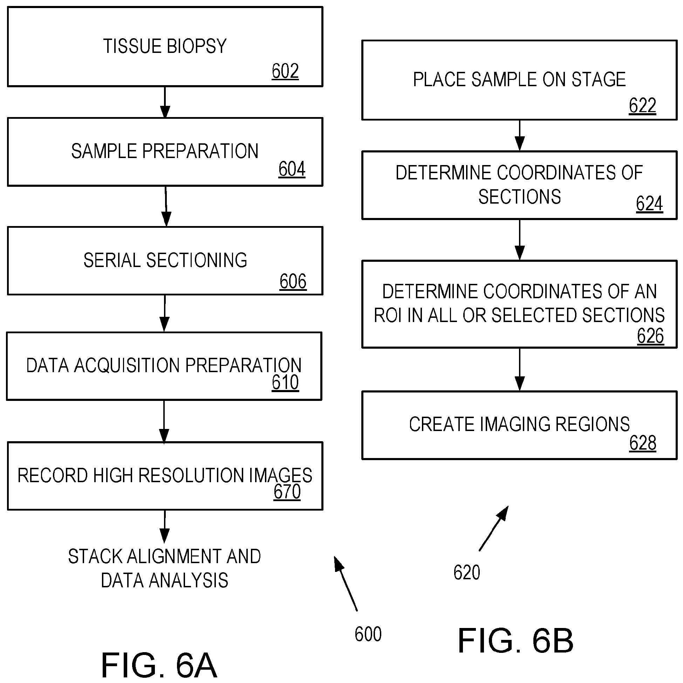

A representative method 600 is illustrated in FIGS. 6A-6E. Referring to FIG. 6A, an animal or tissue biopsy is performed at 602, and at 604, the sample is prepared for imaging. The biopsy tissue is trimmed to a block that is smaller than 2 mm³. In addition, the block is subjected to some or all of chemical fixation, heavy metal staining, and resin infiltration and curing, and trimmed for serial sectioning. Typical resin blocks have a frontal surface area of 0.5-2 mm² and are 0.5-2 mm thick. The resin block is serially sectioned at 606 with an ultra-microtome into multiple 40-100 nm thick sections. The sections are collected on a substrate such as tape, a glass plate, or a wafer. If tapes are used, one or several lengths of tape are glued onto a wafer or metal plate. This collection of sections on a substrate is referred to as an "array tomography sample" or simply as a "sample." In some cases, the collection can extend onto multiple substrates, all of which can be included in the array tomography sample. The sample is then prepared at 610 for unattended data acquisition as discussed further below with reference to FIGS. 6B-6D and high resolution images are obtained at 670.

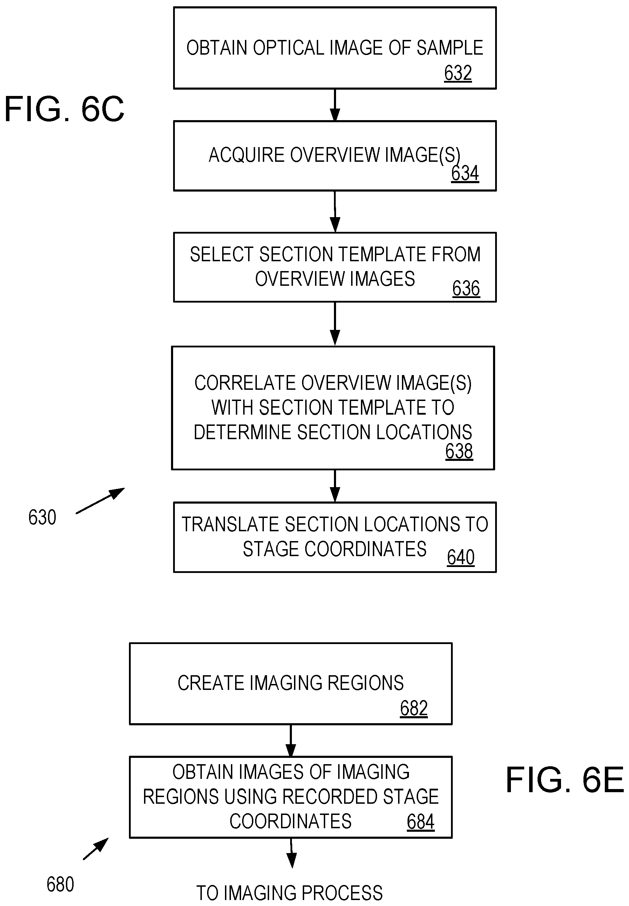

A method 620 of data acquisition preparation such as used at 610 above is illustrated in FIG. 6B. At 622, the sample is placed on a microscope specimen stage and coordinates of all sections on the sample are determined at 624. The determination of section coordinates is further discussed below with reference to FIG. 6C. After section coordinates are obtained, at 626 coordinates of an ROI in all or selected sections are obtained. At 628, imaging regions are created for the selected sections. In some cases, an optical image of the entire array tomography sample is recorded in the SEM. This image shows all or the majority of sections at a coarse resolution and can be used to define areas for acquisition of overview images.

Referring to FIG. 6C, a method 630 of determining section coordinates includes obtaining an optical image of the sample at 632. This image can be used to define sample areas for which overview images are acquired at 636. The overview images show multiple sections and can be single images or image mosaics. The resolution of overview images is comparably coarse, i.e. 1-2 µm pixel size, so that the entire substrate can be imaged within reasonable time. No correlation between the number of images and the number of sections is necessary. One image may show several sections, or multiple images may be required to show a single section. This depends on the maximum field of view of the microscope and on the size of the sections. In some cases, overview images are acquired by different means outside of the SEM. After importing such overview images, they must be aligned so that section positions in the imported images correspond to stage coordinates of the same sections on the array tomography sample. This can be achieved by an alignment in which two or three landmarks visible in both SEM images and in the imported images are manually matched.

The overview images are used as follows. A selected area (typically rectangular) is chosen by the user from the overview images at 636. The selected area is copied from the overview image(s) to serve as a section template. In an automatic procedure, the section template is correlated with the overview images at 638 to determine section locations in the overview images. The matching locations in overview images are translated into positions in a stage coordinate system at 640, i.e., the stage position of each section is stored. Moving the stage to one of the stored positions centers the respective section under the microscope imaging system (the "pole piece"). Any sections not found by the automatic procedure can be added by the user by marking them in the overview images. Any falsely recognized sections (i.e., non-sections) can be noted as false positives and deleted from the list of found sections.

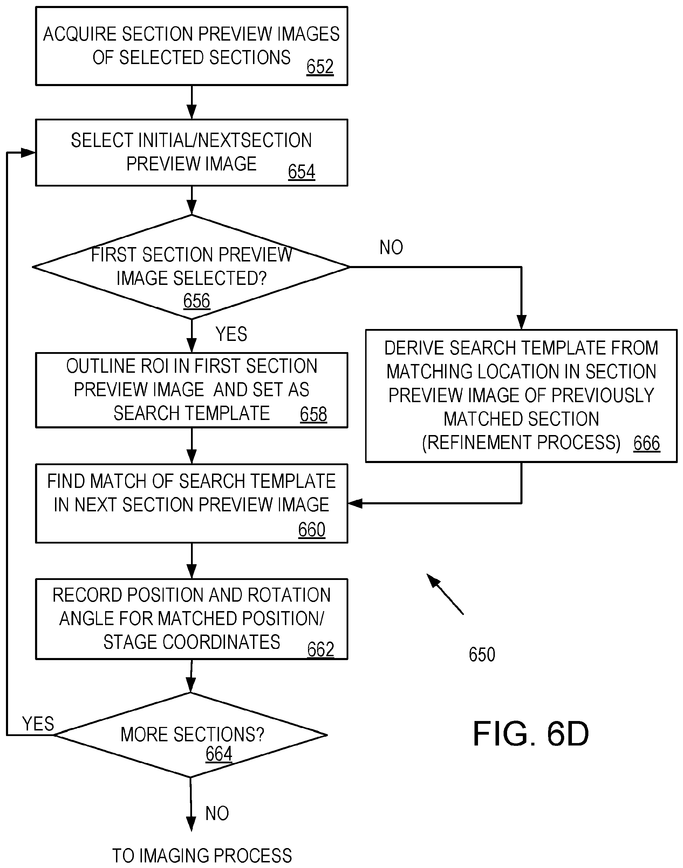

FIG. 6D illustrates a method 650 of determining coordinates of an ROI across all sections. At 652, section preview images are acquired. Section preview images typically have the same or higher resolution than overview images. In some examples, a pixel size of 200-800 nm is used. At 654, a section preview image is selected and at 656, it is determined if the selected section preview image is of the first section. If so, the ROI is noted in the first section preview image by, for example, outlining on a display device using a computer pointing device and stored as a search template at 658. At 660, a match of the search template in the next section preview image is identified, and the associated position and angle stored and/or translated into stage coordinates at 662. If it is determined at 664 that additional sections are to be processed, a next section preview image is selected at 654 and the search template is updated to the matching location in the previously evaluated section preview image at 666. After each section preview image is processed for matching to the search template, the matching area of this section preview image is set at the search template. In this way, the search for matching areas is refined at each step.

Once all sections are processed for alignment as discussed above, images are obtained using a method 680 illustrated in FIG. 6E. Imaging regions are defined by a user on any of the sections at 682, and corresponding regions selected for other sections. At 684, images of the imaging regions are obtained. In typical examples, pixel resolutions are between 5 and 50 nm and a field of view is between 30²µm² and 100²µm². Because stage coordinates for each of the sections have been obtained, the method 680 can be executed by a processor without user intervention. In FIGS. 6A-6E, a single imaging region is used, but in other examples, two or more imaging regions can be aligned. In addition, stage movements can be minimized.

### Example 8. Section Location, Alignment, and High Resolution Imaging

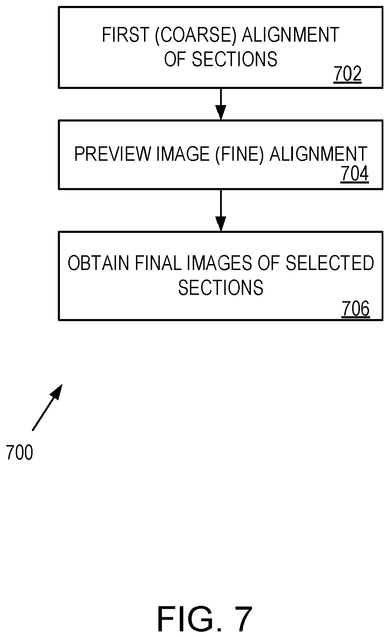

Referring to FIG. 7, a typical method 700 includes performing a first alignment 702 that locates the sections of a sample, typically using correlation based on a user-identified section image. This can be referred to for convenience as a coarse alignment. At 704, the located sections are aligned using preview images that include selected portions of the located sections. An ROI of a preview image is selected as a search template to align other preview images, and the search template updated using a most recently aligned preview image. This can be referred to for convenience as a fine alignment. At 706, final images (such as high resolution image) are obtained that form an aligned or alignable stack of images of at least part of the ROI and suitable for 3D tomographic reconstruction.

### Example 9. Preparatory Alignment

As discussed above, image alignment is used to obtain a stack of aligned images. Image alignment is used during a preparatory phase, i.e., before recording high resolution images. Acquired image stacks are thus already reasonably well aligned, especially around the ROI in which refinement was done. Residual position error is then relatively small, for example, <10 µm. Another round of stack alignment is needed after recording, but the amount of shift is <10 µm. By contrast, acquiring high resolution images with low accuracy imaging region placement and them performing stack alignment, positioning error is typically >100 µm. With this approach >100 µm of border would be need to be added to the size of recorded images to be sure that the ROI is captured in all sections. This would lead to dramatically increased imaging time. As noted above, in the disclosed approaches, acquired image stacks are well aligned around the ROI, and such a border is not needed.

For example, for an ROI that is a 40 µm by 40 µm square and a desired resolution of 4 nm/pixel, an ideal image size is 10,000 by 10,000 pixels. With an imaging area positioning error of +/-10 µm, an image size needed to capture the ROI in all sections would be ROI size +2 x 10 µm, or 60 µm by 60 µm. The recording image size is then 15,000 by15,000 pixels; the increase in imaging time is 15,000²/10,000² = 2.25. With an imaging area positioning error of +/-100 µm, an image size needed to capture the ROI in all sections would be ROI size +2 x 100 µm = 240 µm x 240 µm. The recording image size is then 60,000 by 60,000 pixels; the increase in imaging time is 60,000²/10,000² = 36. It is thus apparent that requiring a large border can significantly increase image acquisition time.

### Example 10. Section Alignment and Distortion

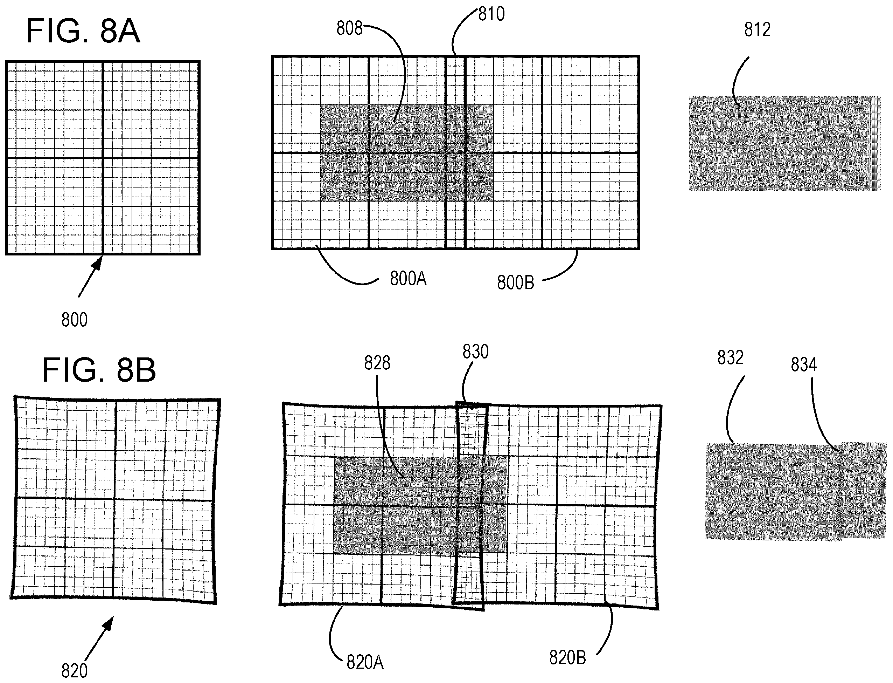

FIGS. 8A-8F illustrate processing of image sections situated on a tape with and without image alignment and show the effects of pincushion distortion in a field of view. Other image artifacts such as image rotations, variable magnifications, focus errors, and other image aberrations can be similarly compensated, and distortion is shown as a convenient illustration. As discussed previously, such image artifacts can lead to misalignment in image stacks based on sections of a specimen and in stitching images of a single section together to form a complete image of the section. FIGS. 8A-8B illustrate representative images 812, 832 obtained with nominally square fields of view that are associated with imaged fields of view 800, 820. (Imaged field of view refers to an actual instrument field of view as imaged by the instrument). The imaged field of view 800 is an intended field of view, absent imaging defects, while the imaged field of view 820 exhibits pincushion distortion. In these examples, section dimensions are nearly the same as a corresponding field of view dimension. In FIG. 8A, a specimen section 808 is imaged using imaged fields of view 800A, 800B that have an overlap area 810. Image portions associated with the overlap area 810 align and the images obtained with the fields of view 800A, 800B can be accurately stitched together to produce the image 812. Thus, with such an imaged field of view, images associated with sections at different locations in the field of view can be stitched together. In FIG. 8B, a specimen section 828 is imaged using distorted imaged fields of view 820A, 820B that have an overlap area 830. In the overlap area, the imaged field of view is distorted, and the distortions are different in the corresponding portions of the imaged fields of view 820A, 802B. Image portions associated with the overlap area 830 can be combined, but without accurate alignment. The combined images associated with imaged fields of view 820A, 820B produce the section image 832 but with an error region 834 in which alignment is incorrect or portions of one or both of the stitched together images can be missing. Thus, with such a distorted imaged field of view, images associated with sections at different locations in the field of view of are not readily stitched together. This stitching difficulty is present for images of sections that are differently situated within multiple fields of view.

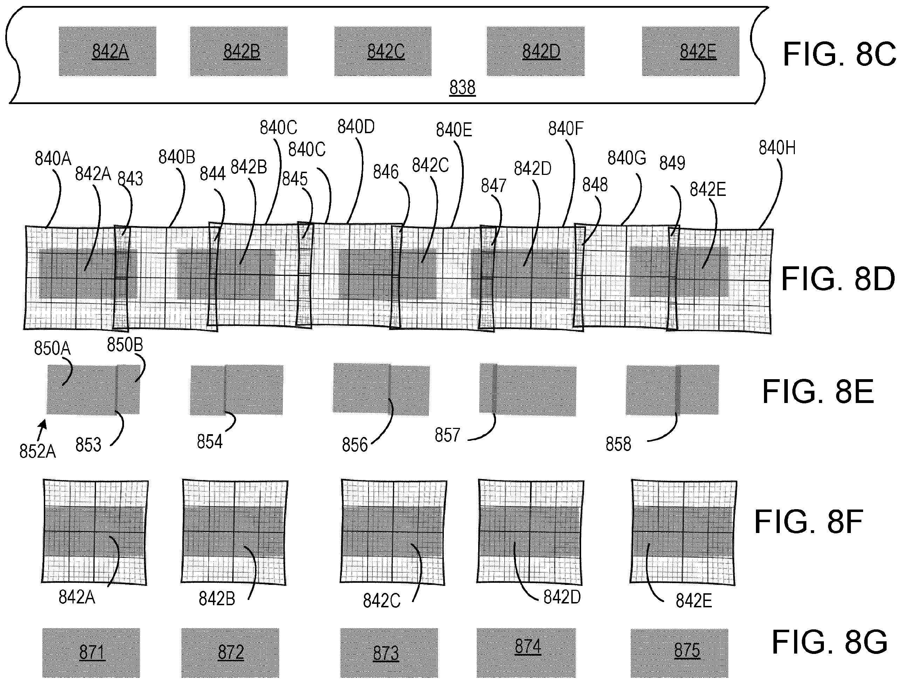

FIG. 8C shows a series of sections such as representative sections 842A-842E situated on a tape 838. As shown in FIG. 8D, the sections 842A-842E are imaged with different respective overlap areas 843-849 in distorted imaged fields of view 840A-840H. Each section is fully imaged in two fields of view in this example. Section dimensions can be 1-2 mm high by 2-3 mm long and often barely fit in a field of view. This arrangement of sections is typically produced with sections placed on the tape 838 in a cutting process Each section is generally fully imaged only by stitching together images of the section in two locations in the imaged fields of view 840A-840H. Adjacent images are associated with the overlap areas 843-849. These overlap areas are associated with image defects, limiting stitching accuracy and producing image portions in offset areas 853-858 as shown in FIG. 8E that impair stitching. For example, image 852A of the section 842A includes portions 850A, 850B associated with fields of view 840A, 840B, respectively, and the portion in the offset area 853 that is associated with the overlap area 843. Referring to FIG. 8G, using preview images and alignment, the sections 842A-842E can be centered or otherwise aligned with respect to the field of view and within a single field of view as shown in FIG. 8F. The distorted imaged field of view 840 produces images 871-875 that may contain distortions but that lack overlap areas associated with stitching errors, as shown in FIG. 8G.

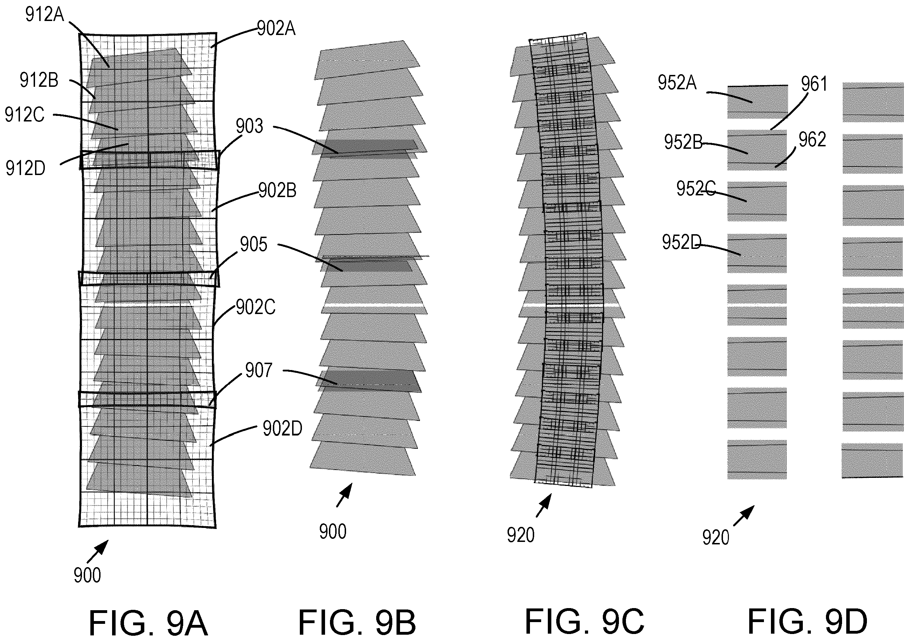

FIGS. 9A-9D illustrate alignment of a representative stack 900 that includes 16 specimen sections such as representative sections 912A-912D that contact adjacent sections. Such an arrangement of sections can be referred to as a ribbon of sections and can be produced in specimen cutting without a tape. Such sections can have aspect ratios of 1:3. 1:4, or 1:5, for example, and the sections can be longer and not as high as sections produced with a tape as shown in FIG. 8C. As shown in FIG. 9A, the sections are imaged in imaged fields of view 902A-902B, in which each field of view images (at least partially) four different sections. Distortion in the imaged fields of view 902A-902D is associated with offset regions 903, 905, 907 that impair stitching together image portions from different imaged fields of view. Using preview images, an aligned image stack 920 is produced in which all section images have substantially the same position in the field of view and without need for image stitching as shown in FIG. 9C-9D. For example, representative images 952A-952D of sections 912A-912D have a common alignment in a single field of view and do not require stitching. Because section edges contact in this example, the image 952B of section 912B also includes image portions 961, 962 that are associated with sections 912A, 912C. Other section images can similarly contain portions associated with adjacent sections. In performing alignment of a particular section, portions of an intended section should be used, not portions of adjacent sections.

In view of the many possible embodiments to which the principles of the disclosed technology may be applied, it should be recognized that the illustrated embodiments are only preferred examples. We claim as our invention all that comes within the scope of the appended claims.

## Claims

1. A method, comprising, with a processor:
obtaining (108) one or more overview images (200) that include image areas associated with a plurality of serial sections (206, 220, 221) of a biological specimen that are disposed on a substrate (202);
processing (110, 111) the one or more overview images (200) to identify image areas (208, 209, 212) associated with the serial sections;
establishing (110, 111) locations of the plurality of sections (206, 220, 221) on the substrate (202);
obtaining (112, 652) a set of preview images (262) associated with a series of the sections, wherein the preview images correspond to user-selected regions of interest; and
processing (114, 115, 116) each of the preview images of the set of preview images to register the preview images,
**characterized in that**
establishing locations (110, 111) of the sections includes associating each section location with a stage coordinate obtained by positioning the substrate to generate a section image of each section of the plurality of sections;
the section locations and image data are stored;
each of the preview images (262) is associated with a respective specimen section; and
wherein the preview images (262) are processed for registration based on either:
alignment of at least one feature in one or more of the preview images (262);
a reference preview image selected from the set of preview images (262); or
a correlation with a search template selected from the set of preview images.

2. The method of claim 1, wherein the section images have resolutions that are higher than resolutions associated with the preview images, wherein the section images are registered based on the registered preview images.

3. The method of either of claims 1-2, wherein the set of preview images includes N preview images 0, ... , N, wherein N is an integer, and at least one preview image is processed for registration based on a search template selected from the set of preview images.

4. The method of claim 3, wherein the i^{th} preview image is registered by comparison with an (i-1)^{th} preview image, wherein i is an integer greater than one and less than N.

5. The method of any preceding claim, wherein processing each of the preview images of the set of preview images to register the preview images further comprises storing image transformations associated with the alignment of the recognized features.

6. The method of any preceding claim, wherein the one or more overview images (200) are obtained from an optical imager (351, 108) and the preview images (262) are obtained from a charged particle beam (CPB) imaging system (300).

7. The method of claim 1, wherein the preview images are associated with a first resolution, and further comprising obtaining a set of region of interest (ROI) images having a second resolution based on the registered preview images, wherein the second resolution is higher than the first resolution.

8. A system, comprising:
a substrate stage (322) arranged to support a substrate (202), the substrate (202) including a plurality of serial sections (206, 220, 221) of a biological specimen arranged thereon; and
at least one imaging system (351, 108, 300) situated to obtain one or more overview images (200) of the plurality of specimen sections and to produce preview images (262) associated with a series of the sections of the biological specimen, wherein each preview image is associated with a respective section and wherein the preview images (262) correspond to user-selected regions of interest;
**the system characterized by**
at least one image processor (302, 400, 402) that is coupled to the at least one imaging system (351, 108, 300) and that is configured to:
receive the one or more overview images (200) and the preview images (262);
process (110, 111) the one or more overview images (200) to identify image areas (208, 209, 212) associated with the serial sections;
establish (110, 111) locations of the sections (206, 220, 221) on the substrate (202) by positioning the substrate to generate an image of each section of the plurality of sections, wherein the establishing includes associating each section location with a substrate stage coordinate based on the one or more overview images (200);
process (114, 115, 116) each of the preview images of the set of preview images to register the preview images; and
store the section locations and image data,
wherein the preview images (262) are processed for registration based on either: alignment of at least one feature in one or more of the preview images (262); a reference preview image selected from the set of preview images (262); or a correlation with a search template selected from the set of preview images.

9. The system of claim 8, wherein the at least one imaging system comprises an optical imaging system (351, 108) and a charged particle beam (CPB) imaging system (300).

10. The system of claim 9, wherein:
the optical imaging system (351, 108) is configured to obtain the overview image;
the CPB imaging system (300) is configured to produce the preview images and to produce region of interest (ROI) images associated with each of the sections; and
the at least one image processor is configured to register the ROI images based on the registration of the preview images.

11. The system of any one of claims 8-10, wherein the overview image has a first resolution, the preview images have a second resolution that is higher than the first resolution, and the ROI images have a third resolution that is higher than the second resolution.

12. The system of any one of claims 8-11, wherein the at least one image processor (351, 108, 300) is configured to:
locate image portions associated with the plurality of sections based on correlation with a section template; and
register the preview images based on correlation with one or more search templates or based on feature identification.

## Patentansprüche

1. Verfahren, das mit einem Prozessor Folgendes umfasst:
Erhalten (108) eines oder mehrerer Übersichtsbilder (200), die Bildbereiche einschließen, die mit einer Vielzahl von Serienschnitten (206, 220, 221) einer biologischen Probe verbunden sind, die auf einem Substrat (202) angeordnet sind;
Verarbeiten (110, 111) des einen oder der mehreren Übersichtsbilder (200), um die Bildbereiche (208, 209, 212), die mit den Serienschnitten verbunden sind, zu identifizieren;
Ermitteln (110,111) der Positionen der Vielzahl von Schnitten (206, 220, 221) auf dem Substrat (202);
Erhalten (112, 652) eines Satzes von Vorschaubildern (262), die mit einer Reihe von Schnitten verbunden sind, wobei die Vorschaubilder Regionen von Interesse entsprechen, die vom Benutzer ausgewählt werden; und Verarbeiten (114, 115, 116) jedes der Vorschaubilder des Satzes von Vorschaubildern, um die Vorschaubilder zu registrieren,
**dadurch gekennzeichnet, dass**
das Ermitteln der Positionen (110, 111) der Schnitte das Zuordnen jeder Schnittposition zu einer Tischkoordinate einschließt, die durch Positionieren des Substrats erhalten wird, um ein Schnittbild jedes Schnitts der Vielzahl von Schnitten zu erzeugen;
die Schnittpositionen und Bilddaten gespeichert werden;
jedes der Vorschaubilder (262) mit einem entsprechenden Probenschnitt verbunden ist; und
wobei die Vorschaubilder (262) für die Registrierung verarbeitet werden, auf der Grundlage von Folgendem: Ausrichten von mindestens einem Merkmal in einem oder mehreren der Vorschaubilder (262); ein Referenz-Vorschaubild, das aus dem Satz von Vorschaubildern (262) ausgewählt wird; oder einer Korrelation mit einer aus dem Satz von Vorschaubildern ausgewählten Suchvorlage.

2. Verfahren nach Anspruch 1, wobei die Schnittbilder Auflösungen aufweisen, die höher sind als die mit den Vorschaubildern verbundenen Auflösungen, wobei die Schnittbilder auf Grundlage der registrierten Vorschaubilder registriert werden.

3. Verfahren nach einem der Ansprüche 1 - 2, wobei der Satz von Vorschaubildern N Vorschaubilder 0, ..., N einschließt, wobei N eine ganze Zahl ist, und mindestens ein Vorschaubild für die Registrierung auf Grundlage einer aus dem Set von Vorschaubildern ausgewählter Suchvorlage verarbeitet wird.

4. Verfahren nach Anspruch 3, wobei das i-te Vorschaubild durch Vergleich mit einem (i-1)-te Vorschaubild registriert wird, wobei i eine ganze Zahl größer als eins und kleiner als N ist.

5. Verfahren nach einem der vorstehenden Ansprüche, wobei das Verarbeiten jedes der Vorschaubilder aus dem Satz von Vorschaubildern zum Registrieren der Vorschaubilder ferner das Speichern von Bildtransformationen umfasst, die mit der Ausrichtung der erkannten Merkmale verbunden sind.

6. Verfahren nach einem der vorstehenden Ansprüche, wobei das eine oder die mehreren Übersichtsbilder (200) von einem optischen Bildgeber (351, 108) erhalten werden und die Vorschaubilder (262) von einem Bildgebungssystem mit geladenem Teilchenstrahl (CPB, Charged Particle Beam) (300) erhalten werden.

7. Verfahren nach Anspruch 1, wobei die Vorschaubilder mit einer ersten Auflösung verbunden sind, und wobei das Verfahren ferner das Erhalten eines Satzes von Bildern der Region von Interesse (ROI, Region of Interest) mit einer zweiten Auflösung auf der Grundlage der registrierten Vorschaubilder umfasst, wobei die zweite Auflösung höher ist als die erste Auflösung.

8. System, umfassend:
einen Substrattisch (322), der zum Aufnehmen eines Substrats (202) ausgelegt ist, wobei das Substrat (202) eine Vielzahl von Serienschnitten (206, 220, 221) einer darauf angeordneten biologischen Probe umfasst; und
mindestens ein Bildgebungssystem (351, 108, 300), das so positioniert ist, um ein oder mehrere Übersichtsbilder (200) der Vielzahl von Probenschnitten zu erhalten und Vorschaubilder (262) herzustellen, die mit einer Reihe der Schnitte der biologischen Probe verbunden sind, wobei jedes Vorschaubild mit einem entsprechenden Schnitt verbunden ist und wobei die Vorschaubilder (262) Regionen von Interesse entsprechen, die vom Benutzer ausgewählt werden;
**wobei das System durch Folgendes gekennzeichnet ist:**
mindestens einen Bildprozessor (302, 400, 402), der mit dem mindestens einen Bildgebungssystem (351, 108, 300) verknüpft und für Folgendes konfiguriert ist:
Empfangen des einen oder der mehreren Übersichtsbilder (200) und der Vorschaubilder (262);
Verarbeiten (110, 111) des einen oder der mehreren Übersichtsbilder (200), um die Bildbereiche (208, 209, 212), die mit den Serienschnitten verbunden sind, zu identifizieren;
Ermitteln (110, 111) der Positionen der Schnitte (206, 220, 221) auf dem Substrat (202) durch Positionierung des Substrats, um ein Bild jedes Schnitts der Vielzahl von Schnitten zu erzeugen, wobei das Ermitteln das Zuordnen jeder Schnittposition zu einer Koordinate des Substrattisches auf der Grundlage des einen oder der mehreren Übersichtsbilder (200) umfasst;
Verarbeiten (114, 115, 116) jedes der Vorschaubilder des Satzes von Vorschaubildern, um die Vorschaubilder zu registrieren; und
Speichern der Schnittpositionen und Bilddaten,
wobei die Vorschaubilder (262) für die Registrierung verarbeitet werden, auf der Grundlage von Folgendem: Ausrichten von mindestens einem Merkmal in einem oder mehreren der Vorschaubilder (262); ein Referenz-Vorschaubild, das aus dem Satz von Vorschaubildern (262) ausgewählt wird; oder einer Korrelation mit einer aus dem Satz von Vorschaubildern ausgewählten Suchvorlage.

9. System nach Anspruch 8, wobei das mindestens eine Bildgebungssystem ein optisches Bildgebungssystem (351, 108) und ein Bildgebungssystem mit geladenem Teilchenstrahl (CPB, Charged Particle Beam) (300) umfasst.

10. System nach Anspruch 9, wobei:
das optische Bildgebungssystem (351, 108) so konfiguriert ist, dass es das Übersichtsbild erhält, das CPB-Bildgebungssystem (300) so konfiguriert ist, dass es die Vorschaubilder herstellt und
dass es die Bilder der Region von Interesse (ROI, Region of Interest) herstellt, die mit jedem der Schnitte verbunden sind; und
der mindestens eine Bildprozessor so konfiguriert ist, dass er die ROI-Bilder auf der Grundlage der Registrierung der Vorschaubilder registriert.

11. System nach einem der Ansprüche 8 - 10, wobei das Übersichtsbild eine erste Auflösung aufweist, die Vorschaubilder eine zweite Auflösung aufweisen, die höher als die erste Auflösung ist, und die ROI-Bilder eine dritte Auflösung aufweisen, die höher als die zweite Auflösung ist.

12. System nach einem der Ansprüche 8 - 11, wobei der mindestens eine Bildprozessor (351, 108, 300) für Folgendes konfiguriert ist:
Lokalisieren der Bildabschnitte, die mit der Vielzahl von Schnitten verbunden sind, auf der Grundlage der Korrelation mit einer Schnittvorlage; und
Registrieren der Vorschaubilder auf Grundlage der Korrelation mit einer oder mehreren Suchvorlagen oder auf Grundlage der Merkmalsidentifikation.

## Revendications

1. Procédé comprenant les étapes consistant à, au moyen d'un processeur :
obtenir (108) une ou plusieurs images d'aperçu (200) qui comprennent des zones d'image associées à une pluralité de sections en série (206, 220, 221) d'un échantillon biologique qui sont disposées sur un substrat (202) ;
traiter (110, 111) une ou plusieurs images d'aperçu (200) afin d'identifier des zones d'images (208, 209, 212) associées aux sections en série ;
établir (110, 111) les emplacements de la pluralité de sections (206, 220, 221) sur le substrat (202) ;
obtenir (112, 652) un ensemble d'images de prévisualisation (262) associées à une série de sections, les images de prévisualisation correspondant à des régions d'intérêt choisies par un utilisateur ; et
traiter (114, 115, 116) chacune des images de prévisualisation de l'ensemble d'images de prévisualisation pour enregistrer les images de prévisualisation,
**caractérisé en ce que**
l'établissement des emplacements (110, 111) des sections comprend l'association de chaque emplacement de section à une coordonnée de platine obtenue en positionnant le substrat pour générer une image de section de chaque section de la pluralité de sections ;
les emplacements de section et les données d'image sont stockés ;
chacune des images de prévisualisation (262) est associée à une section d'échantillon respective ; et
dans lequel les images de prévisualisation (262) sont traitées pour un enregistrement sur la base soit de : l'alignement d'au moins une caractéristique dans une ou plusieurs images de prévisualisation (262) ; une image de prévisualisation de référence choisie dans l'ensemble d'images de prévisualisation (262) ; ou une corrélation avec un modèle de recherche de l'ensemble d'images de prévisualisation.

2. Procédé selon la revendication 1, dans lequel les images de section présentent des résolutions qui sont supérieures aux résolutions associées aux images de prévisualisation, les images de section étant enregistrées sur la base des images de prévisualisation enregistrées.

3. Procédé selon l'une quelconque des revendications 1-2, dans lequel l'ensemble d'images de prévisualisation comprend N images de prévisualisation 0, ... , N, dans lequel N est un nombre entier, et au moins une image de prévisualisation est traitée pour un enregistrement sur la base d'un modèle de recherche choisi dans l'ensemble d'images de prévisualisation.

4. Procédé selon la revendication 3, dans lequel la x^{ième} image de prévisualisation est enregistrée par comparaison avec une (x-1)^{ième} image de prévisualisation, x étant un nombre entier supérieur à un et inférieur à N.

5. Procédé selon l'une quelconque des revendications précédentes, dans lequel le traitement de chacune des images de prévisualisation de l'ensemble d'images de prévisualisation pour enregistrer les images de prévisualisation comprend en outre le stockage des transformations d'image associées à l'alignement des caractéristiques reconnues.

6. Procédé selon l'une quelconque des revendications précédentes, dans lequel une ou plusieurs images d'aperçu (200) sont obtenues à partir d'un dispositif d'imagerie optique (351, 108) et les images de prévisualisation (262) sont obtenues à partir d'un système d'imagerie à faisceau de particules chargées (CPB) (300).

7. Procédé selon la revendication 1, dans lequel les images de prévisualisation sont associées à une première résolution, et comprend en outre l'obtention d'un ensemble d'images de région d'intérêt (ROI) présentant une deuxième résolution basée sur les images de prévisualisation enregistrées, la deuxième résolution étant supérieure à la première résolution.

8. Système comprenant :
une platine de substrat (322) disposée pour supporter un substrat (202), le substrat (202) comprenant une pluralité de sections en série (206, 220, 221) d'un échantillon biologique disposé sur celui-ci ; et
au moins un système d'imagerie (351, 108, 300) situé pour obtenir une ou plusieurs images d'aperçu (200) de la pluraliité des sections d'échantillon et pour produire des images de prévisualisation (262) associées à une série de sections de l'échantillon biologique, chaque image de prévisualisation étant associée à une section respective, et les images de prévisualisation (262) correspondant à des régions d'intérêt choisies par un utilisateur ;
**Système caractérisé par**
au moins un processeur d'image (302, 400, 402) qui est couplé à au moins un système d'imagerie (351, 108, 300) et qui est configuré pour :
recevoir la ou les images d'aperçu (200) et les images de prévisualisation (262) ;
traiter (110, 111) la ou les images d'aperçu (200) afin d'identifier des zones d'image (208, 209, 212) associées aux sections sériées ;
déterminer (110, 111) les emplacement des sections (206, 220, 221) sur le substrat (202) en positionnant le substrat de manière à générer une image de chaque section de la pluralité de sections, la détermination comprenant l'association de chaque emplacement de section à une coordonnée de la platine de substrat sur la base d'une ou plusieurs images d'aperçu (200) ;
traiter (114, 115, 116) chacune des images de prévisualisation de l'ensemble d'images de prévisualisation pour enregistrer les images de prévisualisation ; et
stocker les emplacements de section et les données d'image,
dans lequel les images de prévisualisation (262) sont traitées pour un enregistrement sur la base soit de : l'alignement d'au moins une caractéristique dans une ou plusieurs images de prévisualisation (262) ; une image de prévisualisation de référence choisie dans l'ensemble d'images de prévisualisation (262) ; ou une corrélation avec un modèle de recherche de l'ensemble d'images de prévisualisation.

9. Système selon la revendication 8, dans lequel au moins un système d'imagerie comprend un système d'imagerie optique (351, 108) et un système d'imagerie à faisceau de particules chargées (CPB) (300).

10. Système selon la revendication 9, dans lequel :
le système d'imagerie optique (351, 108) est configuré pour obtenir l'image d'aperçu ; le
système d'imagerie CPB (300) est configuré pour produire les images d'aperçu et pour produire des images de région d'intérêt (ROI) associée à chaque section ; et
au moins un processeur d'image est configuré pour enregistrer les images de ROI sur la base de l'enregistrement des images de prévisualisation.

11. Système selon l'une quelconque des revendications 8-10, dans lequel l'image d'aperçu présente une première résolution, les images de prévisualisation présentent une deuxième résolution supérieure à la première résolution et les images de ROI ont une troisième résolution supérieure à la deuxième résolution.

12. Système selon l'une quelconque des revendication 8-11, dans lequel au moins un processeur d'image (351, 108, 300) est configuré pour :
localiser les parties d'image associées à la pluralité de sections sur la base d'une corrélation avec un modèle de section ; et
enregistrer les images de prévisualisation en fonction d'une corrélation avec un ou plusieurs modèles de recherche ou sur la base de l'identification des caractéristiques.
